# EUROPÄISCHE PATENTANMELDUNG

(11) **EP 1 956 654 A2**
(43) Veröffentlichungstag der Anmeldung: **13.08.2008**
(21) Anmeldenummer: 08002221.3
(22) Anmeldetag: 06.02.2008
(51) Int. Cl.: H01L 25/07, H01L 23/66, H03K 17/10, H03K 17/722

(54) **Halbleiterschalter für Hochspannungen**

(30) Priorität: 07.02.2007 DE 102007006827
(71) Anmelder: BARTELS, Oliver, D-85435 Erding (DE)
(72) Erfinder: BARTELS, Oliver, D-85435 Erding (DE)

(57) **Zusammenfassung**

Mit dieser Erfindung wird ein neuartiger Hochspannungshalbleiterschalter vorgestellt, welcher aus aus einem Stapel von Thyristor-Chips besteht, der durch ein Millimeterwellensignal synchron getriggert wird. Durch eine geeignete Anordnung von Wellenleitern ist eine extrem kompakte Bauweise bei gleichzeitig sehr hoher Schaltgeschwindigkeit infolge geringer Eigeninduktivität möglich. Die Anordnung benötigt zudem keine separaten Bauelemente außerhalb der Thyristorchips auf der jeweiligen Teilspannungsebene, wodurch sehr hohe Spannungen und Ströme mit geringem Kostenaufwand geschaltet werden können.

## Beschreibung

Der Erfindung liegt die Aufgabe zugrunde, einen Halbleiterschalter für hohe Spannungen und hohe Ströme zu konstruieren, welcher gleichzeitig zur Erzielung einer hohen Schaltgeschwindigkeit eine geringe Eigeninduktivität infolge einer kompakten Bauweise aufweist.

Bekannt nach dem Stand der Technik sind zunächst mechanische Schalter, die hier wegen ihrer hohen Trägheit beim Schaltvorgang nicht weiter diskutiert werden sollen, sie sind für sehr schnelle oder sehr häufige (periodische) Schaltvorgänge ungeeignet.

Weiterhin bekannt sind Kaskaden von Halbleiterschaltelementen, bei den Schaltelementen sind für hohe Spannungen primär der Thyristor und IGBT interessant, in letzter Zeit kommen MOSFET-Transistoren hinzu.

Der Thyristor bleibt nach einem einmaligen Zündimpuls leitfähig, bis das der Strom unterbrochen oder umgepolt wird, dies kann durch einen zweiten Thyristor bewerkstelligt werden und wird als Kommutierung bezeichnet. Thyristoren haben den Vorteil, dass sie zum Schalten extrem hoher Ströme geeignet sind. Demgegenüber können IGBT und MOSFETs den Stromfluß auch selber unterbrechen, verkraften aber verglichen mit Thyristoren nur kleinere Ströme. Ein besonderer Fall ist der MOS Controlled Thyristor, ein Beispiel findet sich in EP0565349B1.

Während der gewöhnliche Thyristor gezielt an einer Stelle gezündet wird, ist es für Thyristoren, welche hohe Puls- oder Entladeströme schalten sollen, sehr wichtig, dass die Zündung möglichst auf der gesamten Chipoberfläche durch verteilte Gate-Kontakte gleichzeitig erfolgt. Andernfalls würde der zunächst nur von einem Teilbereich des Chips geschaltete Strom diesen Teilbereich thermisch überlasten, wenn ein bestimmter Stromanstieg dI/dt überschritten wird.

Da der einzelne Thyristor technologiebedingt lediglich einige tausend Volt schalten kann, wird eine Serienschaltung vorgenommen, für diese ist eine gleichzeitige synchronisierte Zündung ebenfalls extrem wichtig, da ansonsten kurzzeitig die maximal zulässige Sperrspannung einzelner zu spät zündender Thyristoren in der Kaskade überschritten wird, was zur Zerstörung dieser führen kann. In EP0752750B1 wird ein Beispiel für eine sehr spezialisierte Serienschaltung gegeben und der Stand der Technik weiter ausgeführt.

Das Problem bei der Serienschaltung von Halbleiterschaltelementen zur Schaltung hoher Spannungen und Ströme besteht demnach primär in der gleichzeitigen Ansteuerung und möglichst breiten Verteilung des Ansteuersignals über die Halbleiteroberfläche.

Während die Verteilung bei niedrigen Spannungen noch durch den Ansatz des MOS Controlled Thyristors (MCT) unterstützt wird, ist bei hohen Spannungen die Aufgabenstellung durch das jeweils unterschiedliche Spannungsgrundniveau der einzelnen Halbleiterschaltelemente in der Serienschaltung extrem erschwert.

Bei einer Serienschaltung von beispielsweise 30 Thyristoren mit je 2000V Spannungsfestigkeit zur Erreichung einer Gesamtspannungsfestigkeit von 60kV liegt beim tatsächlichen Ausnutzen dieser Spannungsfestigkeit das Referenzniveau des Eingangs mindestens eines Schaltelements auf jedenfalls 58kV. Wenn dieses Schaltelement ebenso bedient werden soll wie das Schaltelement am anderen Ende der Serienschaltung, von dessen Referenzniveau der Schaltimpuls ausgeht, so muss der Schaltimpuls über eine Barriere von 58kV mit gleicher Geschwindigkeit übertragen werden wie zu dem Schaltelement, zu dem in diesem Fall keine Barriere notwendig wäre. Selbst im unwahrscheinlichen Fall einer mittigen Ansteuerung besteht im Beispiel noch das Erfordernis einer Barriere von 29kV für mindestens zwei Schaltimpulse.

Bisherige Lösungen sehen vor, die Halbleiterschaltelemente entweder optisch oder induktiv anzusteuern. Ein Beispiel für die induktive Ansteuerung stellt DE 3630775C2 da, hierbei wird ein das Ansteuersignal führender Draht durch mehrere Ferritübertrager geführt, wodurch diese gleichzeitig auf der Sekundärseite einen Ansteuerimpuls für das jeweilige Halbleiterschaltelement abgeben.

Nachteilig hierbei ist, dass die volle Spannungsfestigkeit an jedem Übertrager gewährleistet werden muss, pro Spannungsebene ein Übertrager notwendig ist, und im Fall der Verwendung gewöhnlicher Thyristoren keine schnelle Unterverteilung auf dem Halbleiterchip erfolgt, wodurch der maximal zulässige Stromanstieg dI/dt begrenzt ist.

Bei den optischen Schaltern können optisch schaltbare Thyristoren, ein Beispiel ist in DE102004025082B4, ein weiteres in EP0400153B gegeben, zu einer Serienschaltung zusammengeführt und beispielsweise über Lichtwellenleiter getriggert werden. Nachteilig ist hierbei einerseits der hohe Aufwand, da zu jedem Halbleiterschaltelement ein eigener Lichtwellenleiter geführt werden muss, um die zum Triggern nötige Lichtintensität zu erreichen, andererseits wieder das Problem der fehlenden schnellen Unterverteilung des Zündimpulses auf dem Halbleiterchip. Hinzu kommen inherente Laufzeittoleranzen der optischen Empfänger bei den Halbleiterschaltern, welche wiederum die Schaltung von Strömen mit hoher dI/dt Steilheit erheblich erschweren. Die Thematik kaskadierter optisch angesteuerter Halbleiterschalter ist in DE3935379A1 aufgeführt, allerdings hat sich dieser Aufbau als wenig praktikabel herausgestellt.

Alternativ kann man eine elektrische Kaskade aufbauen, wobei die Halbleiterschaltelemente auf einer Ebene durch ihren Schaltvorgang den Ansteuerimpuls für die nächste Ebene nach dem Prinzip einer Kettenreaktion generieren, dabei benötigt durch die Kettenschaltung die Ausbreitung des Ansteuerimpulses über alle Stufen allerdings sehr lange, wodurch diese Art des Schalters nur für kleinere Spannungen und einen geringen dI/dt Stromanstieg geeignet ist. Ein Beispiel für eine zweistufige elektrische Verschaltung liefert US5379089, bei weiteren Stufen wird die zwangsläufige Addition der Reaktionszeiten der einzelnen Stufen zum entscheidenden Hindernis.

Das Problem wird erfindungsgemäß durch die in Patentanspruch 1 beschriebene Einrichtung gelöst, deren Funktion im folgenden anhand eines Ausführungsbeispiels erläutert wird:

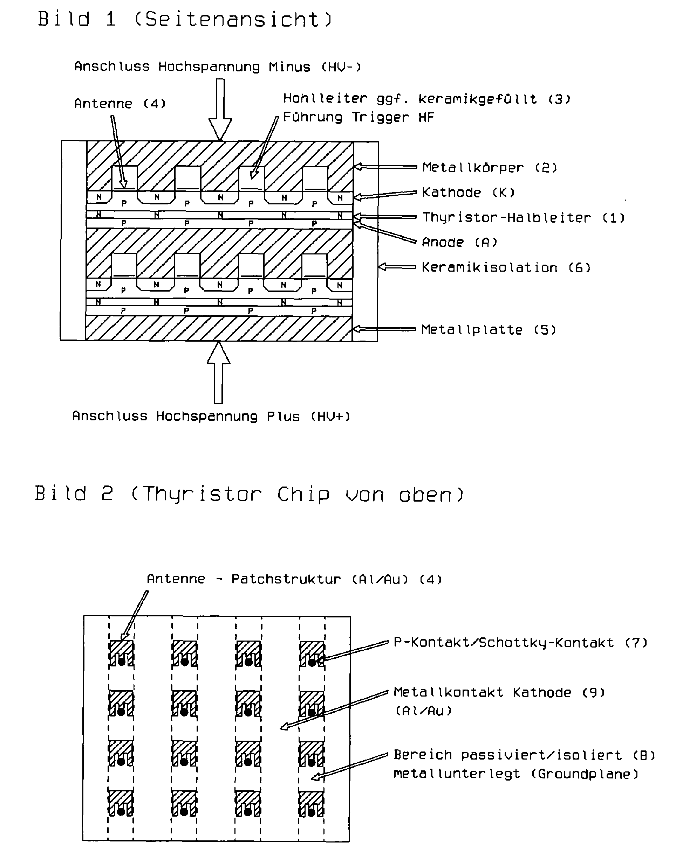

Das Beispiel in Bild 1 zeigt einen Hochspannungsschalter, welcher gemäß der bevorzugten Bauweise mit Thyristoren aufgebaut ist, da diese neben einer hohen Spannungsfestigkeit auch Schaltfähigkeiten für hohe Ströme aufweisen. Der Elektronenstrom fließt dabei bei den bekannten Thyristoren nach Zündung von der auf der Oberfläche angebrachten Kathodenkontaktierung auf kürzestem Weg zur Anode auf der Thyristor-Unterseite. Alternativ sind auch andere Halbleiterschaltelemente wie IGBTs oder MOSFETs denkbar.

Zunächst wird ein Stapel von Thyristorchips (1) (international wird der "Chip" auch als "Die" bezeichnet) entsprechend Bild 1 gebildet, in dem diese mit Zwischenlagen aus Metallkörpern (2) abwechselnd geschichtet werden. Die Metallkörper enthalten hierbei Schlitze, welche drei Seitenflächen des Hohlleiters bilden, die vierte Seitenfläche wird durch die Metallisierung auf dem Thyristorchip gebildet, siehe hierzu den metallunterlegten Bereich (8) in Bild 2. Abgeschlossen wird der Stapel durch eine Metallplatte (5) zum elektrischen Anschluss der hier zu schaltenden positiven Hochspannung (HV+). Der negative Pol (HV-) befindet sich am äußersten Metallkörper (2).

Die Metallisierung (8) stellt einerseits die Masse für die Hochfrequenz da und befindet sich andererseits auf Kathodenpotenzial, so dass sie gleichzeitig an jenen Stellen (9), an denen der Metallkörper (2) direkt auf der Chipoberfläche aufliegt, als Kathodenkontakt genutzt werden kann.

Die Metallisierung ist innerhalb des Hohlleiters in regelmäßigen Abständen mit Patchantennen (4) versehen, welche das Hochfrequenzsignal auskoppeln. Diese Antennenform hat den Vorteil, dass sie sich problemlos mittels Fotolitographie herstellen lässt. Anstelle der Patchantennen sind auch andere Formen der Auskopplung wie z.B. Drahtstrukturen (Bonddraht) oder eine angekoppelte Streifenleiter-Leitung (Microstrip), welche auf dem Halbleiterchip realisiert ist, denkbar.

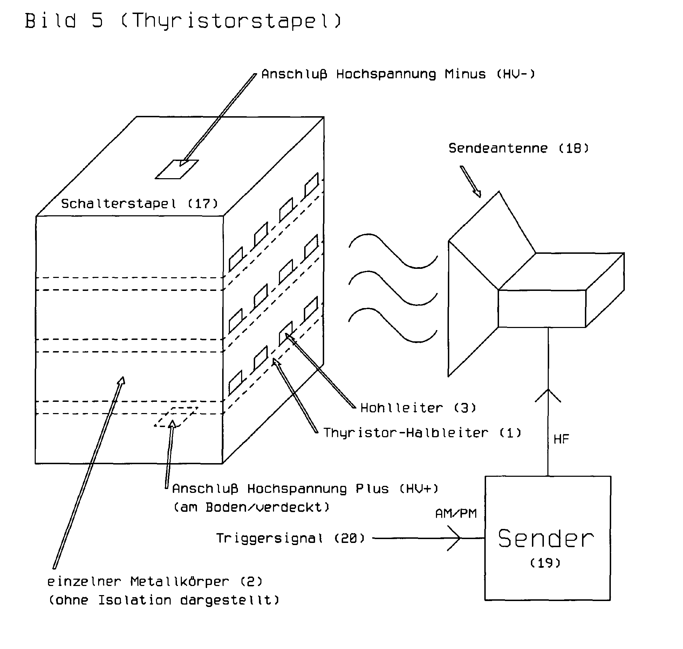

Die Hohlleiter im fertigen Thyristorstapel (17) werden nun entsprechend Bild 5 genau dann mit einem Hochfrequenzsignal aus einem externen Sender (19) via externer Sendeantenne (18) versorgt, wenn mittels Triggersignal (20) ein Einschaltvorgang durch Zündung der Thyristoren beabsichtigt ist. Der Ausschaltvorgang erfolgt wie bei Thyristoren üblich beispielsweise durch Kommutierung.

Durch die über den gesamten Chip verteilten Antennen wird der besondere Vorteil der Erfindung deutlich: Die Thyristoren erhalten das Zündsignal flächig auf dem gesamten Chip und nahezu gleichzeitig mit fast Lichtgeschwindigkeit auf allen Ebenen des Thyristorschalters, ohne dass hierzu weitere externe elektronische Bauteile benötigt werden oder die Potenzialtrennung der verschiedenen Thyristor-Spannungsebenen Aufwand verursacht. Durch die so realisierbare kompakte Bauweise wird die unerwünschte parasitäre Induktivität des Schalters auf ein Minimum reduziert, gleichzeitig ist durch die flächige Metallkontaktierung der Oberfläche eine gute Wärmeabfuhr gewährleistet, welche zusätzlich durch Flüssigkühlung unterstützt werden kann.

Der Raum wird innerhalb der Hohlleiter vorteilhafterweise mit einer Keramik mit hoher Dielektrizitätskonstante aufgefüllt, um die erforderlichen Abmessungen des Hohlleiters auf zum HalbleiterChip kompatible Dimensionen zu reduzieren. Alternativ kann der Hohlleiter durch Einbringung eines Drahtes, insbesondere gehalten durch das Dielektrikum, zum Koaxialleiter umfunktioniert werden. Theoretisch können die Antennen auch zu einem Microstrip zusammengefasst werden, welcher den Schlitz des Hochfrequenz-Hohlleiters oder Koaxialleiters im Sinne eines Richtkopplers nach außen abschließt, dann allerdings mit höheren Hochfrequenzverlusten. Im Falle der Verwendung eines Drahtes zur Bildung eines Koaxialleiters ist an den Außenseiten des Stapels in den meisten Fällen die Anbringung weiterer Antennen zur Einleitung der Hochfrequenz erforderlich.

Der gesamte Stapel wird mechanisch von einer Keramikumhüllung (6) zusammengehalten, welche gleichzeitig eine Isolation darstellt und die Welleneinleitung zu den Hohlleitern übernimmt. Eine Abstufung der Dielektrizitätskonstanten des Materials kann hierbei sinnvoll sein, um unerwünschte Reflexionen der Hochfrequenz oder unerwünscht hohe Feldstärken zu vermeiden bzw. um das Hochfrequenzsignal per dielektrischer Wellenleitung zu führen.

Die Auslösung des Triggers wird vornehmlich mit einem Mikrowellen- oder Millimeterwellensignal erfolgen, dies ergibt sich schon aus den Dimensionserfordernissen der Hohlleiter innerhalb des Thyristorstapels. Denkbar wäre auch ein steiler Puls mit entsprechend hohem Oberwellenanteil. Entsprechende Puls-Senderkonstruktionen sind aus der Fachliteratur (insbesondere Radarliteratur) bekannt.

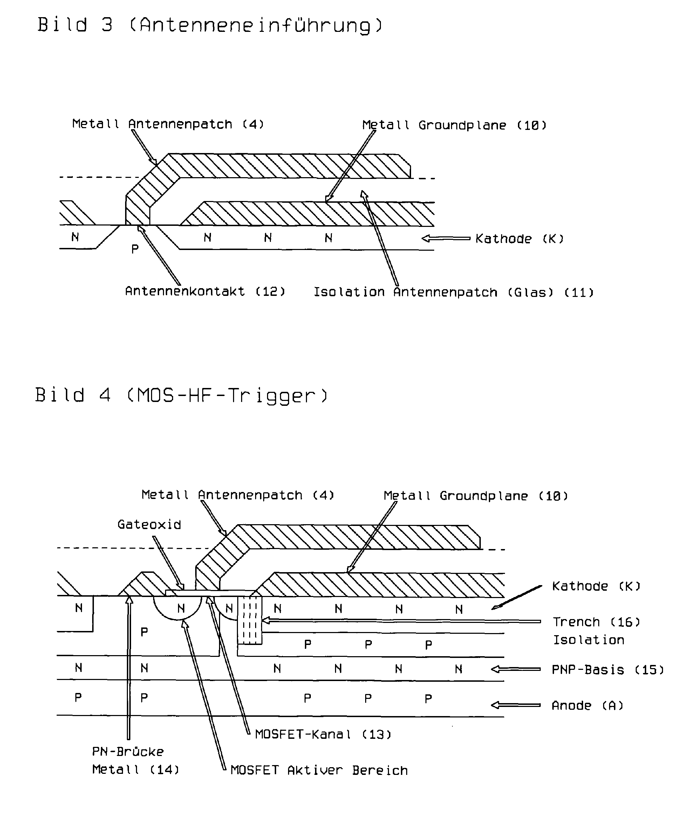

Die Demodulation des Hochfequenzsignals kann einerseits entsprechend dem Schichtaufbau des Halbleiters in Bild 3 direkt am PN Übergang zwischen Gate und Kathode des Thyristors erfolgen, dazu wird das Signal vom Antennenpatch (4) unmittelbar per Antennenkontakt (12) in diese Diode eingeleitet. Die Antenne ruht seinerseits isoliert (11) auf einer Groundplane (10), welche gleichzeitig mit der Kathode (K) verbunden ist und den Gegenpol der Antenne darstellt. Es ist dabei jedoch auf eine geeignete Entkopplung der Hochfrequenz vom Gesamtthyristor zu achten, um die Hochfrequenz effizient zur Zündung einsetzen zu können. Diese Variante dürfte primär für niedrige Frequenzen in Frage kommen.

Eine nicht ganz so offensichtliche weitere Möglichkeit zur Demodulation des Triggersignals ergibt sich jedoch durch die Ausnutzung des Schottky-Kontakts, der entsteht, wenn das Metall des Antennenpatches einen schwach dotierten N-Bereich des Thyristor-Chips berührt. Dabei entsteht eine Schottky-Diode, welche sich durch eine sehr hohe obere Grenzfrequenz auszeichnet. Der Grund hierfür ist die ausschließliche Nutzung von Majoritätsladungsträgern (Elektronen), demzufolge ist eine P-Kontaktierung nicht vorteilhaft. Man wird daher in dieser Ausführungsform den Schnitt in Bild 3 so modifizieren, dass der Antennenkontakt in einen isolierten N-Bereich mündet, welcher über eine PN-Metallbrücke oder Polysilizium-Brücke mit dem P-Bereich des Thyristor-Gates verbunden ist. Diese Metall- oder Polysilizium-Brücke kann gleichzeitig als Kondensator zur Unterstützung der Funktion des des Schottky-Gleichrichters dienen, wenn sie geeignet mit Metall auf einer anderen Lage unterlegt wird, welches mit der Kathode verbunden ist, z.B. mit der isolierten (11) Groundplane (10).

Ein weiterer Weg zum Aufbau eines effizienten Demodulators ist die Zwischenschaltung einer MOSFET-Transistors zwischen Gate und Anode oder der als Basis des PNP-Teiltransistors des Thyristors dienenden N-Schicht. Ein denkbarer Schichtaufbau hierzu ist in Bild 4 gezeigt, die Antenne kontaktiert dabei direkt das Gate oberhalb des MOSFET-Kanals (13), dieser stellt dann im Zündfall bei Eintreffen des Hochfrequenzsignals eine Verbindung zwischen der PNP Basis (15) und dem Thyristor-Gate her. Die auf die Oberfläche geführte PNP-Basis muss dazu unbedingt spannungsfest von der Kathode (K) isoliert werden, dies geschieht im Beispiel mit Hilfe eines Trench-Grabens (16), der mittels anisotroper Ätzung hergestellt und mit einem geeigneten Isolationsmaterial gefüllt werden kann. Wiederum ist eine PN-Brücke aus Polysilizium oder Metall (14) erforderlich, um das Gate des Thyristors mit dem Source des MOSFET zu verbinden.

Bei der Nutzung einer in den Thyristor-Herstellungsprozess integrierten MOSFET-Technologie kann man natürlich - wie aus der Fachliteratur bekannt - auch einen MOS-Controlled-Thyristor (MCT) aufbauen, der über einen zweiten MOSFET wieder gelöscht werden kann. Da dieser zweite MOSFET zu einem anderen Zeitpunkt als der Trigger-MOSFET angesteuert werden muss, ist eine Trennung auf Hochfrequenzseite notwendig.

Es ist hierzu denkbar, einzelne Hohlleiter als Resonatoren abzustimmen, welche lediglich bei einer bestimmten Hochfrequenz ein Signal an die Antennen liefern. Ein Vorteil dieser Maßnahme ist die Störsicherheit, weil durch den so erzeugten Bandpass-Filter mögliche Störsignale, welche zu einer unerwünschten Auslösung führen könnten, bereits im Vorfeld ausgefiltert werden.

Diese Frequenzselektivität kann ebenfalls genutzt werden, um unterschiedliche Schaltfunktionen auszulösen, z.B. den Trigger und die davon getrennte Löschfunktion eines MOS-Controlled-Thyristor.

Natürlich sind im Prinzip auch komplexere digital realisierte Funktionen auf dem Halbleiterschalter-Chip denkbar, beispielsweise kann es vorteilhaft sein, bestimmte Betriebsparameter wie z.B. die Temperatur des Chips oder Störungen umgekehrt vom Chip zur Steuerung per Funk zurück zu übermitteln. Dies kann beispielsweise dadurch geschehen, dass eine Backscatter-Modulation zum Einsatz kommt.

Bei dieser Modulation werden die auf dem Chip angeordneten Antennen selektiv verstimmt, sodass, wenn diese mit einem Hochfrequenzsignal beaufschlagt werden, sich deren Reflexionsverhalten abhängig von der Verstimmung ändert. Diese Änderung der Reflexion kann von einem Empfänger wahrgenommen und die so gewonnene Information ausgewertet werden.

Näheres zu den Möglichkeiten der Backscatter-Modulation findet sich in der RFID-Fachliteratur, welche ebenfalls Optimierungsmöglichkeiten für passive Demodulatoren für die Steuersignale der Halbleiterschaltelemente beschreibt, sofern eine geeignete Betriebsspannung zur Verstärkung und Auswertung aus technologischen Gründen nicht z.B. aus der Hochspannung gewonnen werden kann. Eine nahe liegende Kombination besteht beispielsweise in der Unterbringung von RFID-Funktionen zur Ablage von Fertigungsdaten wie Seriennummern der Halbleiter.

Bei der Auswahl der Halbleiterschaltelemente ist noch zu beachten, dass diese idealerweise im geöffneten Zustand eine identische Restleitfähigkeit aufweisen, um die anstehende Hochspannung weitgehend gleich auf die Schaltelemente zu verteilen. Sollte dies nicht gewährleistet sein, so kann die Spannungsaufteilung durch ein Widerstandsnetzwerk unterstützt werden.

Dieses kann auch als seitlich in die Isolation des Stapels (6) eingearbeitetes Widerstandsband realisiert werden, die Kontaktierung erfolgt dann über die Metallkörper (2) bzw. die abschließende Metallplatte (5), ebenso ist natürlich eine Integration auf den Halbleiter-Chips denkbar. Eine Realisierung von bedarfsweise je nach Anwendung des Schalters erforderlichen Snubber-Elementen kann ebenfalls mittels einem Widerstandsband realisiert werden, die Kondensatoren der Snubber-Elemente können in diesem Fall durch eine geeignete Isolierung beispielsweise mittels Beschichtung zwischen einem Widerstandsband und einem Metallkörper als Plattenkondensator gebildet werden.

Die Anwendungen dieser Erfindung sind vielfältig, sie reichen von schnellen Hochspannungsschaltem für Pulsentladungen für Laser oder Plasmaanwendungen über medizinische Anwendungen wie Geräte zur Zerstörung von Nierensteinen mittels Stoßwellen oder Geräte für die Induktionstherapie bis hin zu industriellen Anwendungen im Bereich der Stromerzeugung und Stromverteilung.

## Patentansprüche

1. Halbleiterschalter für Hochspannungen, wobei mindestens zwei Halbleiterschaltelemente in Serie geschaltet sind, um die zu schaltende Spannung pro Schaltelement zu reduzieren, wodurch mehrere Referenzspannungsebenen entsprechend der Serienschaltung für das Steuersignal der Halbleiterschaltelemente entstehen, wobei mindestens ein Hohlleiter oder koaxialer Leiter existiert, welcher ein Hochfrequenzsignal zu den Schaltelementen weiterleitet, und wobei je Referenzspannungsebene das Hochfrequenzsignal aus dem Leiter teilweise ausgekoppelt wird, um hieraus durch Gleichrichtung oder Demodulation ein Steuersignal für die Halbleiterschaltelemente zu gewinnen,
**dadurch gekennzeichnet, dass** ein Stapel von Halbleiterchips mit den Halbleiterschaltelementen gebildet wird, indem diese mit Zwischenlagen aus Metallkörpern abwechselnd geschichtet werden, welche einerseits die elektrische Verbindung für die Serienschaltung darstellen und andererseits Hohlräume oder Schlitze aufweisen, welche den Hohlleiter oder Koaxialleiter oder einzelne Seitenflächen des Hohlleiters oder Koaxialleiters darstellen, wobei eine weitere Seitenfläche durch die metallisierte Oberfläche des jeweils kontaktierten Chips gebildet wird.

2. Halbleiterschalter nach Anspruch 1, **dadurch gekennzeichnet, dass** die Hohlräume mit einer Keramik oder einem anderen Dielektrikum mit großer relativer Dielektrizitätskonstante ausgefüllt werden, um den für eine bestimmte Signalfrequenz erforderlichen Mindestdurchmesser des Hohlleiters zu reduzieren, wobei die Keramik oder das Dielektrikum eingebettet einen Draht enthält, um alternativ eine koaxiale Leitung zu formen.

3. Halbleiterschalter nach Anspruch 1, **dadurch gekennzeichnet, dass** als Halbleiterschaltelemente Thyristoren eingesetzt werden.

4. Halbleiterschalter nach Anspruch 1, **dadurch gekennzeichnet, dass** als Halbleiterschaltelemente MOSFETs oder IGBTs eingesetzt werden.

5. Halbleiterschalter nach Anspruch 1, **dadurch gekennzeichnet, dass** das Hochfrequenzsignal zunächst einen MOSFET schaltet, welcher seinerseits einen Thyristor auslöst.

6. Halbleiterschalter nach Anspruch 1, **dadurch gekennzeichnet, dass** zur Auskopplung aus dem Hohlleiter Patchantennen oder Streifenleiter (Microstrip) eingesetzt werden, welche sich auf der Chipoberfläche befinden und aus einer Mischung von Metall- und Isolationsschichten gebildet werden, wobei die Groundplane der Antenne gleichzeitig als Kathoden- oder Source-Anschluss des Halbleiterschaltelements genutzt wird.

7. Halbleiterschalter nach Anspruch 1, **dadurch gekennzeichnet, dass** am Übergang einer metallischen Struktur zur Auskopplung des Hochfrequenzsignals beim Übergang in den Halbleiter ein Schottky-Kontakt zur Gleichrichtung der Hochfrequenz gebildet wird.

8. Halbleiterschalter nach Anspruch 1 oder 2, **dadurch gekennzeichnet, dass** der Stapel von Halbleiterchips von einer geeigneten Keramik mit abgestufter relativer Dielektrizitätskonstante umgeben ist, die einerseits für die notwendige mechanische Festigkeit und Isolation sorgt und andererseits ein auf diese Keramik gerichtetes Hochfrequenzsignal zu den Hohlleitern führt, insbesondere mittels einer dielektrischen Wellenleitung.

9. Halbleiterschalter nach Anspruch 1 oder 2, **dadurch gekennzeichnet, dass** die Hohlleiter als Resonatoren abgestimmt sind.

10. Halbleiterschalter nach Anspruch 1 oder 2 oder 6 oder 9, **dadurch gekennzeichnet, dass** die Hohlleiter oder Resonatoren oder Antennen, insbesondere Patchantennen, durch ihre Konstruktionsweise, insbesondere durch Wahl einer geeigneten Hohlleiter-Wellenlänge oder Resonanzfrequenz, die Hochfrequenz so frequenzselektiv weiterleiten, dass durch Wahl unterschiedlicher Frequenzen unterschiedliche Schaltvorgänge ausgelöst werden können.

11. Halbleiterschalter nach Anspruch 10, **dadurch gekennzeichnet, dass** als Halbleiterschaltelement ein MOS Controlled Thyristor (MCT) verwendet wird, dessen einer MOS-Transistor zur Triggerung über eine Frequenz und dessen zweiter MOS-Transistor zur Abschaltung über eine andere Frequenz getriggert wird.

12. Halbleiterschalter nach Anspruch 1 oder 8, **dadurch gekennzeichnet, dass** über ein geeignetes Widerstandsmaterial oder Widerstandsnetzwerk, welches längs der Serienschaltung angebracht ist, eine Aufteilung der anliegenden Spannung in möglichst gleiche Teilspannungen vorgenommen wird, um die Halbleiterschaltelemente mit möglichst gleichen Spannungen zu beaufschlagen, wobei die gebildeten Widerstände zusätzlich auf insbesondere mittels Beschichtung isolierte und somit lediglich kapazitiv wirksame Bereiche der Metallkörper aufgelegt werden, um eine als Snubber-Element bezeichnete Widerstands-Kondensator-Kombination zu bilden, wobei das Widerstandsmaterial dabei flächig an der Seite des Stapels aus Metallkörpern und Chips angebracht wird.

13. Halbleiterschalter nach Anspruch 7, **dadurch gekennzeichnet, dass** die Gleichrichtung des Hochfrequenzsignals unmittelbar am PN Übergang zwischen Gate und Kathode des Thyristors erfolgt, wobei die Dotierung und Strukturierung an diesem Übergang in der Umgebung der Einkoppelstelle des Hochfrequenzsignals hochfrequenztauglich mit geringer Eigenkapazität und Entkopplung von der hochkapazitiven Umgebung realisiert ist, wozu auch eine Strukturierung per zwischengeschalteter metallisierter Drossel bedarfsweise geeignet ist.

14. Halbleiterschalter nach Anspruch 1, **dadurch gekennzeichnet, dass** es sich bei dem Hochfrequenzsignal um ein UHF-Signal, Mikrowellensignal oder Millimeterwellensignal im Frequenzbereich von 300 MHz bis 300 GHz handelt.

15. Halbleiterschalter nach Anspruch 1, **dadurch gekennzeichnet, dass** die Halbleiterschaltelemente Informationen über interne Betriebszustände mittels Backscatter-Modulation über den Hohlleiter zu einer Steuerung zurückkommunizieren.

16. Halbleiterschalter nach Anspruch 1, **dadurch gekennzeichnet, dass** in den Metallkörper zusätzlich Bohrungen zur Durchströmung mit einem nichtleitenden Kühlmittel, insbesondere Öl, eingebracht werden.
